(19) **Europäisches Patentamt / European Patent Office / Office européen des brevets**

(11) **EP 2 216 813 A2**

(12) # EUROPEAN PATENT APPLICATION

(43) Date of publication:
**11.08.2010 Bulletin 2010/32**

(51) Int Cl.:
**H01L 23/58** (2006.01)     **H01L 25/16** (2006.01)

(21) Application number: **09165887.2**

(22) Date of filing: **20.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **05.02.2009 US 365986**

(71) Applicant: **Northern Lights Semiconductor Corp.**
**Saint Paul, MN 55113 (US)**

(72) Inventors:
• **Lai, James Chyi**
  **Saint Paul, MN 55113 (US)**
• **Fong, Kai Chun**
  **Saint Paul, MN 55113 (US)**

(74) Representative: **Mertens, Hans Victor**
**EP&C**
**P.O.Box 3241**
**2280 GE Rijswijk (NL)**

(54) **Integrated circuit package comprising a magnetic capacitor**

(57)     An integrated circuit package including a substrate (110), an integrated circuit (120) and a magnetic capacitor unit (130) as a power source is disclosed. The substrate (110) has a first surface (112) and an opposite second surface (114). The integrated circuit (12) is connected to the second surface (114) of the substrate (110). The magnetic capacitor unit (130) has a positive terminal (132) and a negative terminal (134) connected to the substrate (110). Further, an integrated circuit package including an integrated circuit and a magnetic capacitor unit, which is stacked on said integrated circuit, is disclosed.

Fig. 1

# Description

The present invention relates to an integrated circuit package. More particularly, the present invention relates to an integrated circuit package for magnetic capacitor.

Integrated circuits are typically enclosed by a package that is mounted to a printed circuit board. The package has external contacts that are solder to the printed circuit board and dedicated to the various pins of the integrated circuit such as power, ground and signal. The contacts may be solder balls that are attached to external conductive lands of the package. Packages with external solder balls are typically referred to as ball grid array (BGA) packages.

Integrated circuits such as processors (i.e. CPU, FPGA, ASIC, etc) are commonly seen inside computers and electronic devices. The energy for running the electronics is stored in chemistry inside the system battery. There are many problems associated with utilizing the battery power source from the system. First, a rechargeable battery has a limited number of re-chargings, and as the battery is re-charged towards that limit, the capacity of the battery will start to decrease. Second, a battery has a memory problem. If the battery is only partially charged or charged before the complete depletion of energy, then the capacity of the battery may decrease. Third, expensive power management chips and protocols are required to power processors. The electronics need to travel a long distance before they reach the integrated circuits, thus resulting great energy loss and time inefficiency.

For the forgoing reasons, there is a need for a new type of integrated circuit package with better power source capabilities.

The present invention provides an integrated circuit package for magnetic capacitor including a substrate, an integrated circuit and a magnetic capacitor unit. The substrate has a first surface and an opposite second surface. The integrated circuit is connected to the second surface of the substrate. The magnetic capacitor unit has a positive terminal and a negative terminal connected to the substrate.

The accompanying drawings are included to provide a further understanding of the invention, and are incorporated in and constitute a part of this specification. The drawings illustrate embodiments of the invention and, together with the description, serve to explain the principles of the invention. In the drawings,

Fig. 1 shows an integrated circuit package according to a first embodiment of this invention;
Fig. 2 shows an integrated circuit package according to a second embodiment of this invention;
Fig. 3 shows an integrated circuit package according to a third embodiment of this invention;
Fig. 4 shows an integrated circuit package according to a forth embodiment of this invention; and

Fig. 5 shows an integrated circuit package according to a fifth embodiment of this invention.
Fig. 6 shows a cross section view of a magnetic capacitor cell according to an embodiment of this invention.

Reference will now be made in detail to the present preferred embodiments of the invention, examples of which are illustrated in the accompanying drawings. Wherever possible, the same reference numbers are used in the drawings and the description to refer to the same or like parts.

All figures are drawn for ease of explanation of the basic teachings of the present invention only; the extensions of the figures with respect to number, position, relationship, and dimensions of the parts to form the embodiment will be explained or will be within the skill of the art after the following description has been read and understood.

The magnetic capacitor (MCAP) unit in the following embodiments of this invention has a large amount of capacity. Moreover, the MCAP unit can be applied as a battery without the memory problem associated with batteries. Therefore, the MCAP unit can be fully or partially charged/discharged without loss of performance.

In addition, the MCAP unit can be used to create a large array of devices in parallel to obtain much larger energy storage. Several MCAP units can be stacked up to obtain much larger energy storage.

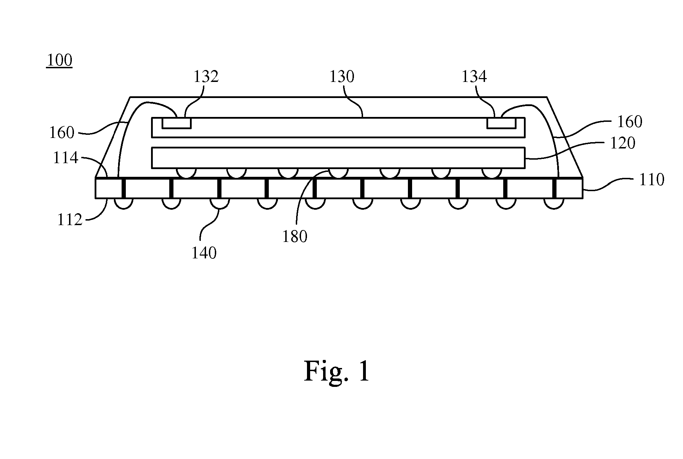

Fig. 1 shows an integrated circuit package 100 according to the first embodiment of this invention. The integrated circuit package 100 includes a substrate 110, an integrated circuit 120, and a magnetic capacitor (MCAP) unit 130. The substrate 110 is typically constructed as a multilayered printed circuit board. It is to be understood that the substrate 110 can be constructed with ceramic co-fired processes as well. The substrate 110 has a first surface 112 and an opposite second surface 114. The integrated circuit 120 is connected to the second surface 114 of the substrate 110. The integrated circuit 120 may be a processor (i.e. CPU, FPGA, ASIC, etc), a processor with power management features, a microprocessor, or any other electronic devices. The MCAP unit 130 has a positive terminal 132 and a negative terminal 134 connected to the substrate 110. The MCAP unit 130 supplies electric power to the integrated circuit 120.

The integrated circuit package 100 may also include solder balls 140 attached to the first surface 112 of the substrate 110. The solder balls 140 are initially attached to the substrate 110 to provide a ball grid array (BGA) package. Although a BGA package is shown and described, it is to be understood that the package may have other external contacts such as pins or solder columns.

In this embodiment, the integrated circuit 120 is connected to the second surface 114 of the substrate 110 via solder balls 180. Typically, the integrated circuit 120 here is a processor with power management features. Thus, the integrated circuit 120 has the control logic circuitry for powering the system and controlling the charge or discharge cycles of the MCAP unit 130.

The substrate 110 may also include structural null connects. The positive terminal 132 and negative terminal 134 of the MCAP unit 130 are connected to the structural null connects of the substrate 110 via lead wires 160.

The integrated circuit package 100 is in a stacked chip-scale package, i.e. a System-in-a-Package (SiP), which is able to meet the demands of manufacturing small, thin, and light products. A large number of integrated circuit chips can be mounted or stacked on another lower chip in this kind of package.

Compared with the conventional integrated circuit package, where the processors are typically powered by the system battery, which may be arranged in a place far away from the processor or/and outside of the integrated circuit package, the embodiment places the MCAP unit inside the package and provides fast and efficient electrical power source to the integrated circuit. Thus, the embodiment can reduce the waste of electrical power and the lost of signals in a great deal.

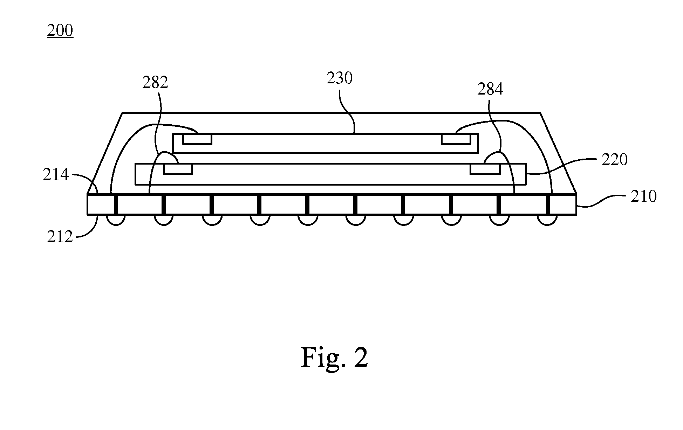

Fig. 2 shows an integrated circuit package 200 according to the second embodiment of this invention. The integrated circuit package 200 includes a substrate 210, an integrated circuit 220, and a MCAP unit 230. The substrate 210 has a first surface 212 and an opposite second surface 214. The integrated circuit package 200 is in a stacked chip package. This embodiment is different from the first one in the way the integrated circuit 220 connects the substrate 210. In this embodiment, the integrated circuit 220 is connected to the second surface 214 of the substrate 210 via lead wires 282 and 284.

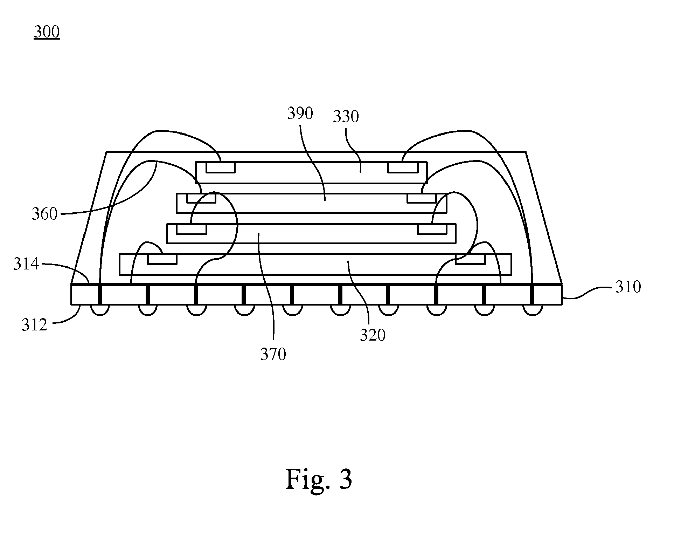

Fig. 3 shows an integrated circuit package 300 according to the third embodiment of this invention. The integrated circuit package 300 includes a substrate 310, an integrated circuit 320, a memory device 370, a MCAP unit 330, and a power management module 390. The substrate 310 has a first surface 312 and an opposite second surface 314. This embodiment is different from the second one in the way that there are a separate power management module 390 and a memory device 370. In this embodiment, instead of integrating the power management module into the integrated circuit 320 such as a processor, the separate power management module 390 handles the power management for the system. The memory device 370 is connected to the second surface 314 of the substrate 310. The power management module 390 are also connected to the structural null connects of the substrate 310 via lead wires 360.

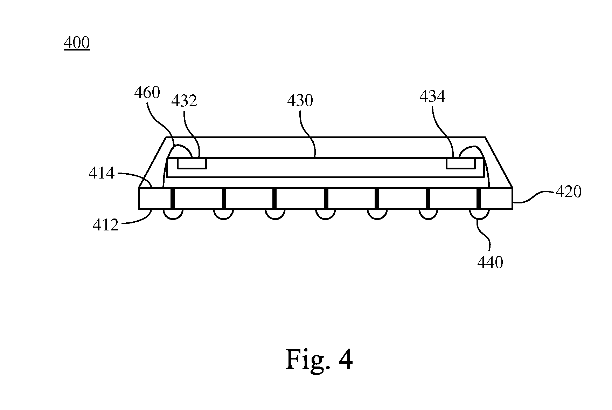

Fig. 4 shows an integrated circuit package 400 according to the forth embodiment of this invention. The integrated circuit package 400 includes an integrated circuit 420 and a MCAP unit 430. The integrated circuit 420 may be served as a substrate as well in this embodiment. The integrated circuit 420 has a first surface 412 and an opposite second surface 414. The MCAP unit 430 is connected to the second surface 414 of the integrated circuit 420. The integrated circuit 420 may be a processor with power management features, a microprocessor with power management features, or any other appropriate electrical devices. The MCAP unit 430 has a positive terminal 432 and a negative terminal 434 connected to the structural null connects of the integrated circuit 420 via lead wires 460. The MCAP unit 430 supplies electric power to the integrated circuit 420. The integrated circuit package 400 may also include solder balls 440 attached to the first surface 412 of the integrated circuit 420 to provide a ball grid array (BGA) package.

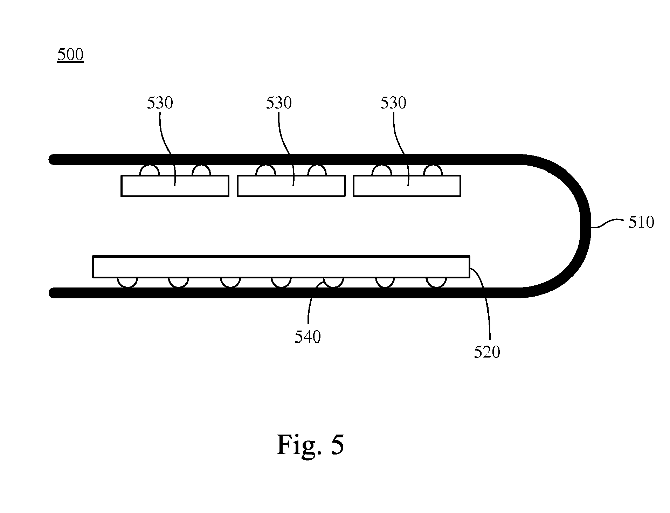

Fig. 5 shows an integrated circuit package 500 according to the fifth embodiment of this invention. The integrated circuit package 500 is a folded package. The integrated circuit package 500 includes a flexible substrate 510, an integrated circuit 520, and MCAP unit 530. The integrated circuit 520 is connected to the substrate 510 via solder balls 540. Each of the MCAP unit 530 has a positive terminal and a negative terminal as solder balls connected the substrate 510.

In another embodiment, the MCAP unit can be arranged in a 3-D System-in-a-Package design, which may have bus for connection and epoxy layers with encapsulated integrated circuits.

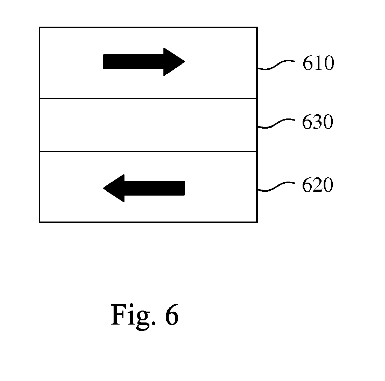

Fig. 6 shows a cross section view of a magnetic capacitor cell according to one embodiment of this invention. The MCAP unit mentioned above includes a plurality of MCAP cells shown in Fig. 6. Each of the MCAP cells includes a first magnetic electrode 610, a second magnetic electrode 620, and a dielectric layer 630 configured between the first magnetic electrode 610 and the second magnetic electrode 620. The dielectric layer 630 is made of insulation material, so electric current won't pass through the dielectric layer 630. The first magnetic electrode 610 and the second magnetic electrode 620 are electrically biased and have magnetic polarization. The arrows shown in Fig. 6 indicate the magnetic polarization. Furthermore, the capacitance of the magnetic capacitor cell can be calculated using the equation (a) as follows:

$$C = \frac{e_0 e_k e_{CMC} A}{r} \qquad \text{(a)}$$

,where $e_0$ is the permittivity of vacuum, $e_k$ is the permittivity of the dielectric layer 630, $e_{CMC}$ is the coefficient due to Colossal Magnetic Capacitance effect, A is the surface area of the dielectric layer 630, and r is the thickness of the dielectric layer 630.

As embodied and broadly described herein, the embodiments effectively provide fast and efficient electrical power source to the integrated circuit by utilizing the MCAP unit as the electrical power source. The embodiments also help achieve the goal of small, thin, and light electronic products.

Although the present invention has been described in considerable detail with reference to certain preferred embodiments thereof, other embodiments are possible. Therefore, the scope of the appended claims should not be limited to the description of the preferred embodiments contained herein.

## Claims

1. An integrated circuit package (100) for magnetic capacitor comprising:

   a substrate (110) having a first surface (112) and an opposite second surface (114);
   an integrated circuit (120) connected to the second surface (114) of the substrate (110); and
   a magnetic capacitor, MCAP , unit (130) having a positive terminal (132) and a negative terminal (134) connected to the substrate (110).

2. The integrated circuit package for magnetic capacitor of claim 1, further comprising a plurality of solder balls (140) attached to the first surface (112) of the substrate (110).

3. The integrated circuit package for magnetic capacitor of claim 1, wherein the integrated circuit (120) is mounted to the substrate.

4. The integrated circuit package for magnetic capacitor of claim 4, wherein the integrated circuit (120) is connected to structural null connects of the substrate (110) via lead wires (160).

5. The integrated circuit package for magnetic capacitor of claim 1, wherein the positive terminal (132) and the negative terminal (134) of the MCAP unit (130) are connected to the substrate (110), in particular to structural null connects of the substrate (110), via a plurality of connecting components, in particular lead wires or solder balls.

6. The integrated circuit package for magnetic capacitor of claim 1, further comprising a memory device (370) connected with the substrate.

7. The integrated circuit package for magnetic capacitor of claim 1, wherein the substrate is a printed circuit board or a flexible packaging substrate.

8. The integrated circuit package for magnetic capacitor of claim 1, wherein the integrated circuit package is in a System-in-a-Package (SiP).

9. An integrated circuit package (400) for magnetic capacitor comprising:

   an integrated circuit (420) having a first surface (412) and an opposite second surface (414); and
   a magnetic capacitor, MCAP , unit (430) having a positive terminal (432) and a negative terminal (434) connected to the second surface (414) of the integrated circuit (420).

10. The integrated circuit package for magnetic capacitor of claim 9, further comprising a plurality of solder balls (440) attached to the first surface (412) of the integrated circuit (420).

11. The integrated circuit package for magnetic capacitor of claim 9, wherein the MCAP unit (430) is connected to structural null connects of the integrated circuit (420) via lead wires (460).

12. The integrated circuit package for magnetic capacitor of claim 1 or 9, wherein the MCAP unit (130, 430) comprises a plurality of MCAP cells.

13. The integrated circuit package for magnetic capacitor of claim 12, wherein each of the MCAP cells comprises:

    a first magnetic electrode (610);
    a second magnetic electrode (620); and
    a dielectric layer (630) configured between the first magnetic electrode (610) and the second magnetic electrode (620).

14. The integrated circuit package for magnetic capacitor of claim 13, wherein the first magnetic electrode (610) and the second magnetic electrode (620) are electrically biased and have magnetic polarization.

15. The integrated circuit package for magnetic capacitor of claim 14, wherein each of the MCAP cells has the capacitance defined as $C = \dfrac{e_0 e_k e_{CMC} A}{r}$,

    where $e_0$ is the permittivity of vacuum, $e_k$ is the permittivity of the dielectric layer (630), $e_{CMC}$ is the coefficient due to Colossal Magnetic Capacitance effect, A is the surface area of the dielectric layer (630), and r is the thickness of the dielectric layer (630).

Fig. 1

Fig. 2

300

Fig. 3

Fig. 4

Fig. 5

Fig. 6